(19) Europäisches Patentamt
European Patent Office
Office européen des brevets

(11) **EP 1 785 506 A1**

(12) # EUROPEAN PATENT APPLICATION

(43) Date of publication:
**16.05.2007 Bulletin 2007/20**

(51) Int Cl.:
***C23C 16/06*** *(2006.01)*  ***B22C 3/00*** *(2006.01)*

(21) Application number: **05447249.3**

(22) Date of filing: **09.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Centre de compétence de l'Ind. Techn. (CRIF) - Kenniscentrum van de Tech. Ind. (WICM) 1030 Brussels (BE)**

(72) Inventors:
 • **Cosemans, Patrick 3300 Tienen (BE)**
 • **Van Stappen, Marc 3545 Halen (BE)**

(74) Representative: **Lerho, Marc J. A. et al Office Van Malderen Bd de la Sauvenière 85/043 B-4000 Liège (BE)**

(54) **Protective coating for casting moulds**

(57)     The present invention is related to a mould for non-ferrous metal casting, said mould comprising on its inner surface a protective layer, said protective layer comprising a nickel interlayer in direct contact with said inner surface of said mould and a tungsten finishing layer covering said nickel interlayer.

W top layer

Ni interlayer

mould

10 µm

Fig. 1

EP 1 785 506 A1

**Description**

**Field of the invention**

The present invention is related to a protective coating of moulds for non-ferrous metal casting and in particular to a mould comprising a protective coating realised by deposition of a duplex coating of pure nickel and pure tungsten by a particular CVD technique as a protection against the attack and soldering of molten non-ferrous metals such as aluminum, copper, zinc and magnesium.

**Introduction and state of the art**

Non-ferrous metal casting, and particularly aluminum casting is performed using moulds that are preheated. For steel moulds, a chemical reaction occurs at the interface where molten non-ferrous metals and in particular aluminum comes into contact with the iron. This results in the formation of intermetallic compounds and the sticking of aluminum to the mould. This soldering leads to high maintenance costs and a decreased productivity. The die soldering mechanism is described in "Mechanism and Preventing Measures for Die Soldering during Al Casting in a Ferrous Mould", S. Shankar, D. Apelian, JOM, August 2002, p. 47.

Various solutions exist in order to protect a steel mould surface. To protect the steel mould during high-pressure die casting, a lubricating coating is sprayed on the inner surface prior to each injection of liquid aluminum. For example, patent GB 2 315 034 describes an aqueous release agent used in steel moulds for aluminum casting. To protect the steel mould during gravity or low-pressure die casting, a ceramic coating is deposited. Patent WO 00/56481 describes the thermal spraying of a ceramic powder together with a polymer binder, the coating being heated afterwards.

US patent 2,839,292 of Bellamy, issued June 17, 1958 describes that molybdenum and tungsten coatings on metal parts are highly resistant to attack when immersed in molten aluminum. The coatings can be applied by spraying (which is preferred), plating or cladding. The patent utilises an outer ceramic layer to protect the parts from oxidation. In the claims, only the use of molybdenum on a ferrous metal is described.

The American patent US-2002-119343 of Betts, issued August 29, 2002 describes the use of high-density coatings consisting of a metal from groups Vb, VIb or VIIb metals and preferably molybdenum or tungsten in pure or alloyed form, as a protective coating against the attack of molten aluminum or zinc on articles in the form of a bearing, bushing, sleeve, coupling or roller. The thickness of the coating is between 0,25mm and 7,6mm. The deposition method includes plasma-transferred arc, welding overlay and high-velocity arc spraying processes.

The chemical vapour deposition process (CVD) can be used to deposit uniform, highly dense and pure coatings on substrates and on items of complex shape (K.L. Choy, "Chemical vapour deposition of coatings", Progress in Materials Science 48, 2003, pp. 57-170).

In a typical CVD process for the deposition of composite coatings, the substrate is heated in the reaction chamber, and the previously mixed gas reagents are then introduced into this chamber. By varying the composition of the reaction mixture and of the parameters of the process (temperature of the substrate, composition of the reaction mixture, flow rate, total pressure in the reaction mixture, temperature of the gases supplied, etc.), it is possible to obtain a variety of coatings (K.L. Choy, "Chemical vapour deposition of coatings", Progress in Materials Science 48, 2003, pp. 57-170).

In a hot wall CVD reactor, substrates as well as the reactor wall and the mixture of gases are heated in the reaction chamber. This implies that the gas reaction not only occurs at the substrate surface but also spontaneously in the reactor. This is known as "gas phase reaction". To minimise these reactions, the deposition process is performed at a low reactor pressure (K.L. Choy, "Chemical vapour deposition of coatings", Progress in Materials Science 48, 2003, pp. 57-170).

The tungsten coating can be formed out of the thermal decomposition of $WF_6$ mixed with $H_2$ and Ar at a temperature between 380°C and 600°C. Nickel can be deposited by CVD: several chemical reactions exist (Handbook of Chemical Vapour Deposition, H.O. Pierson, 1999, Noyes Publications, USA).

Other solutions proposed to prevent the aluminum from sticking to the mould are the application of a metal oxide coating (patent US 3,865,608) based on a solution of dissolved metal oxides and subsequently heating of the moulds to 750°C, or the creation of casting moulds out of heavy metal alloys via powder metallurgy (WO 00/10752).

Patent WO 00/47796 gives a method for the formation of a tungsten carbide coating that can be used as a hard protective layer on moulds to increase the life time of the tool. The inventors claim the thermal preheating of the gas mixtures used. To deposit these coatings on steel moulds the authors suggest depositing an intermediate layer resistant to chemical attack of fluorides.

The tungsten coating can be deposited also on top of other intermediate layers to optimise the thermal management of the interior part of the casting moulds. The thickness of these coatings and their thermal properties define this thermal management.

**Aims of the invention**

The present invention aims to provide a mould for non-ferrous metal casting equipped with a protective layer allowing a substantial lifetime increase and a process for the application of such a protective layer.

**Summary of the invention**

The present invention discloses a mould for non-ferrous metal casting, said mould comprising on its inner surface a protective layer, said protective layer comprising a nickel interlayer in direct contact with said inner surface of said mould and a tungsten finishing layer covering said nickel interlayer.

According to preferred embodiments of the present invention, the present application discloses one or several of the following features:

- the mould is a steel mould;
- the non-ferrous metals are selected from the group consisting of aluminum, zinc, copper and magnesium;
- the non-ferrous metal is aluminum;
- the tungsten-finishing layer is obtained by chemical vapour deposition;
- the nickel interlayer and said tungsten-finishing layer are both obtained by chemical vapour deposition;
- the nickel interlayer and said tungsten-finishing layer are both obtained by hot wall chemical vapour deposition;
- the nickel interlayer and said tungsten-finishing layer are both obtained by hot wall chemical vapour deposition in the same CVD machine;
- the nickel interlayer and said tungsten-finishing layer are both obtained by hot wall chemical vapour deposition below 600°c.

The present invention further discloses a process for the manufacturing of a protective layer on a mould for non-ferrous metal casting comprising the following subsequent steps:

- depositing a nickel interlayer on the inner surface of a mould by a chemical vapour deposition technique;
- depositing a tungsten-finishing layer on said nickel interlayer by a chemical vapour deposition technique.

Finally, the present invention discloses the use of a duplex nickel/tungsten layer, the nickel layer being the interlayer and a tungsten-finishing layer covering said nickel interlayer, as a protective layer on the inner surface of a steel mould for aluminum casting.

**Short description of the drawings**

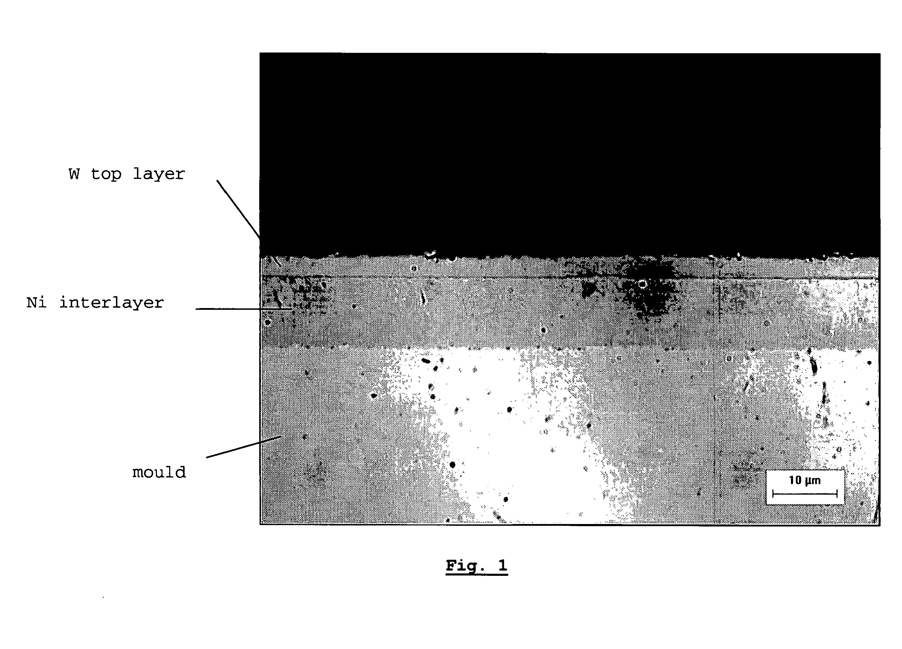

Fig. 1 represents a cross-section of the nickel interlayer with a thickness of $10\mu$m and a top layer of tungsten with a thickness of $4\mu$m.

**Detailed description of the invention**

It is obvious from the prior art that various protective layer exist, preventing molten non-ferrous materials such as aluminum, zinc, copper and magnesium to stick to the moulds.

The application of an aqueous lubricant is very time consuming and needs to be done with a lot of care. Each spot on the mould where no lubrication is applied will result in aluminum build-up and a possible production stop. The aqueous solutions can initiate corrosion of the moulds and their pigments can contaminate the aluminum products. Ceramic coatings applied on moulds for gravity and low-pressure die casting requests high personnel costs in spraying the powder to the moulds. In both cases the efficiency of the applied solutions is not proven scientifically. Both the aqueous solutions as the ceramic powders sprayed on the mould surfaces have a limited performance and have to be repeated frequently.

The use of metal oxide and carbide coatings is presented, primarily as a protection of the steel mould to improve the tool lifetime. However, it is very important that the molten non-ferrous metals such as aluminum cool down quickly. For the oxide and carbide coatings the thermal conductivity is lower than for the pure tungsten coating. The thermal management of the chosen tungsten coating solution can further be improved by varying the thickness and by the deposition of intermediate layers with other thermal properties.

Patent application US-2002-119343 describes the application of tungsten as being highly resistant against the attack of molten aluminum. However, the patent does not describe the use of tungsten coating on the inner surface of steel moulds and it does not mention the hot wall CVD technology as a way to deposit the coating. The same can be said for patent WO 00/10752 where powder metallurgy is used to integrate tungsten parts in the casting mould.

Patent WO 00/47796 suggests the application of an intermediate coating for chemically active materials which is resistant to the attack of fluorides in a CVD deposition process of tungsten carbides. It does not mention the integrated one cycle low pressure, hot wall CVD process where at first a nickel layer is deposited and subsequently tungsten coating.

A solution to the problems described above, is provided by the present invention relating to the application of a duplex nickel and tungsten coating deposited by means of low pressure, hot wall low pressure CVD onto steel moulds which will be used in contact with molten aluminum.

Tungsten coatings deposited by CVD are characterised by a lower thermal expansion towards the steel mould which initiates large compressive stresses acting against tensile stresses resulting in a good adhesion of the coating. Tungsten itself shows a limited solubility of non-ferrous metals such as aluminum. Tungsten coatings behave as good thermal conductors that are effective in high-pressure die-casting where quick cooling of the aluminum product is needed. The CVD process leads to a well uniform deposition even of the interior parts of complex shaped moulds. All these characteristics result in an extended life time and stability of the moulds for gravity casting, low pressure die casting and high pressure die casting in contact with liquid non ferrous metals such as aluminum.

The deposition technique of the protective layer of the present invention is a low-pressure, hot-wall chemical-vapour deposition, where in an integrated process both layers are subsequently deposited.

The moulds, generally steel moulds, to be coated are degreased at first in a solvent bath. The moulds are placed in the CVD reactor. After closing the reactor, it is purged with argon 5 times using an automatic cycle filling the reactor with argon to a pressure of 600mbar whereafter the reactor is pumped down to a pressure of 100mbar. After this purging cycle the reactor undergoes a leakage test. If it passes the leakage test, the reactor and the moulds inside are brought to a temperature between 180 and 200°C at a gas pressure of 110mbar. The gas flow of argon and hydrogen are both at 25l/min.

In a second step the nickel intermediate layer is deposited using the following process:

$$Ni(CO)_4 + heat \rightarrow Ni(metallic\ coating) + 4(CO)$$

In a third step the temperature in the CVD reactor is brought to between 500 and 520°C (same process conditions as in first step). When the temperature in the reactor is stable, the gas flows of argon and hydrogen are brought to a higher flux (respectively 45 and 45-90l/min) and preheated WF6 gas (31°C, 3l/min) is introduced in the reactor at a total pressure of 125mbar. During 60 in a 6μm thick layer is deposited. After deposition a 6h cooling stage is being performed with an argon atmosphere inside the reactor.

## Examples

Casting moulds with a dimension of 700mm height and within 500mm diameter have been treated (weight 300kg). The coatings can be applied also on non-blank moulds, e.g. moulds that have been repaired or used before in test runs. The coatings can be removed by a chemical process and can be recoated. The duplex nickel-tungsten coating can be given various thicknesses and other internal layers can be integrated to optimise the thermal management. The thickness of the nickel interlayer varies generally between 10 and 100μm and the thickness of the tungsten layer between 3 and 200μm.

In process the coated moulds can be inspected by a non-destructive coating measurement to predict the further performance of the moulds.

Parts of an aluminum casting mould for gravity casting have been treated as described above. Without the nickel-tungsten coating about 8 hours production time is possible after which a new ceramic protecting layer has to be sprayed on the moulds. With a nickel-tungsten layer according to the present invention the mould lifetime becomes at least 20 times higher.

A metal casting gutter and delivery channel used in contact with molten copper are coated with a tungsten coating with a thickness between 3 and 30μm. The tungsten layer protects the tool against corrosive attack of the molten copper.

Steel moulds for high-pressure die casting of zinc are coated with a nickel-tungsten layer according to the present invention. Reduced sticking of the zinc to the mould increases the process lifetime of the mould.

## Claims

**1.** A mould for non-ferrous metal casting, said mould comprising on its inner surface a protective layer, said protective layer comprising a nickel interlayer in direct contact with said inner surface of said mould and a tungsten finishing layer covering said nickel interlayer.

2. The mould according to Claim 1, wherein said mould is a steel mould.

3. The mould according to Claim 1, wherein said non-ferrous metals are selected from the group consisting of aluminum, zinc, copper and magnesium.

4. The mould according to Claim 1, wherein said non-ferrous metal is aluminum.

5. The mould according to Claim 1, wherein said tungsten finishing layer is obtained by chemical vapour deposition.

6. The mould according to Claim 1, wherein said nickel interlayer and said tungsten-finishing layer are both obtained by chemical vapour deposition.

7. The mould according to Claim 1, wherein said nickel interlayer and said tungsten-finishing layer are both obtained by hot wall chemical vapour deposition.

8. The mould according to Claim 1, wherein said nickel interlayer and said tungsten-finishing layer are both obtained by hot wall chemical vapour deposition in the same CVD machine.

9. The mould according to Claim 1, wherein said nickel interlayer and said tungsten-finishing layer are both obtained by hot wall chemical vapour deposition below 600°C.

10. A process for the manufacturing of a protective layer on a mould for non-ferrous metal casting comprising the following subsequent steps:

   - depositing a nickel interlayer on the inner surface of a mould by a chemical vapour deposition technique;
   - depositing a tungsten-finishing layer on said nickel interlayer by a chemical vapour deposition technique.

11. The process according to Claim 10, wherein said mould is a steel mould.

12. The process according to Claim 10, wherein said non-ferrous metals are selected from the group consisting of aluminum, zinc, copper and magnesium.

13. The process according to Claim 10, wherein said non-ferrous metal is aluminum.

14. The process according to Claim 10, wherein said chemical vapour deposition technique is a hot wall chemical vapour deposition technique.

15. The process according to Claim 10, wherein the deposit of the nickel interlayer and of the tungsten finishing layer occurs below 600°C.

16. Use of a duplex nickel/tungsten layer, the nickel layer being the interlayer and a tungsten-finishing layer covering said nickel interlayer, as a protective layer on the inner surface of a steel mould for aluminum casting.

W top layer

Ni interlayer

mould

10 μm

Fig. 1

EP 1 785 506 A1

**European Patent Office**

**EUROPEAN SEARCH REPORT**

Application Number

EP 05 44 7249

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | S. SHANKAR AND D. APELIAN: "Mechanism and Preventive Measures for Die Soldering during Al Casting in a Ferrous Mold" JOM, August 2002 (2002-08), pages 47-54, XP001246601 * the whole document * | 1-16 | C23C16/06 B22C3/00 |
| A,D | WO 00/56481 A (CAST CENTRE PTY. LTD; JAHEDI, MAHNAZ; GIANNOS, MARY) 28 September 2000 (2000-09-28) * the whole document * | 1-16 | |
| A,D | GB 2 315 034 A (LOTHAR * THONI) 21 January 1998 (1998-01-21) * the whole document * | 1-16 | |
| A | PATENT ABSTRACTS OF JAPAN vol. 2003, no. 12, 5 December 2003 (2003-12-05) -& JP 2005 028398 A (KANUC:KK), 3 February 2005 (2005-02-03) * abstract * | 1-16 | |

TECHNICAL FIELDS SEARCHED (IPC)

C23C
B22C

The present search report has been drawn up for all claims

| Place of search | Date of completion of the search | Examiner |
|---|---|---|
| Munich | 3 March 2006 | Swiatek, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 05 44 7249

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2006

| Patent document cited in search report | | Publication date | Patent family member(s) | | Publication date |
|---|---|---|---|---|---|
| WO 0056481 | A | 28-09-2000 | CN | 1344188 A | 10-04-2002 |
| | | | EP | 1171253 A1 | 16-01-2002 |
| | | | MX | PA01009554 A | 19-08-2003 |
| GB 2315034 | A | 21-01-1998 | NONE | | |
| JP 2005028398 | A | 03-02-2005 | NONE | | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2315034 A
- WO 0056481 A
- US 2839292 A
- US 2002119343 A

- US 3865608 A
- WO 0010752 A
- WO 0047796 A

**Non-patent literature cited in the description**

- **S. SHANKAR ; D. APELIAN.** Mechanism and Preventing Measures for Die Soldering during Al Casting in a Ferrous Mould. *JOM,* August 2002, 47

- **K.L. CHOY.** Chemical vapour deposition of coatings. *Progress in Materials Science,* 2003, vol. 48, 57-170